Europäisches Patentamt

European Patent Office

Office européen des brevets

(11) Veröffentlichungsnummer: **0 297 388**
**A1**

## (12) EUROPÄISCHE PATENTANMELDUNG

(21) Anmeldenummer: 88109820.6

(22) Anmeldetag: 21.06.88

(51) Int. Cl.⁴: **H01H 1/40 , H01H 11/00**

(30) Priorität: 27.06.87 DE 3721316
07.11.87 DE 3737907

(43) Veröffentlichungstag der Anmeldung:
**04.01.89 Patentblatt 89/01**

(84) Benannte Vertragsstaaten:
**ES FR GB IT**

(71) Anmelder: **SWF Auto-Electric GmbH**
**Stuttgarter Strasse 119 Postfach 135**
**D-7120 Bietigheim-Bissingen(DE)**

(72) Erfinder: **Bühler, Roland**
**Raiffeisenstrasse 9**
**D-7100 Heilbronn(DE)**
Erfinder: **Fuchsberger, Peter**
**Winkelhoferstrasse 29**
**D-7930 Ehingen(DE)**

(54) **Elektrischer Schalter, insbesondere Lenkstockschalter für Kraftfahrzeuge.**

(57) Bei einem elektrischen Schalter ist in ein Kunststoffteil eine Stanzplatine aus Metall eingebettet, deren eine Flachseite in weiten Bereichen frei von Kunststoff ist. Um auch in diesen Bereichen einen sicheren Sitz der einzelnen Leiterbahnen der Stanzplatine im Kunststoff zu gewährleisten, weist eine Leiterbahn innerhalb dieses Bereichs einen Abschnitt auf, der tiefer als die Leiterbahn liegt, der mit einer Schmalseite an den Kunststoff der Grundplatte angrenzt und mit dem Leiterbahn in der Grundplatte verankert ist.

Fig. 4

EP 0 297 388 A1

## Elektrischer Schalter, insbesondere Lenkstockschalter für Kraftfahrzeuge

Die Erfindung betrifft einen elektrischen Schalter, insbesondere einen Lenkstockschalter für Kraftfahrzeuge, der die Merkmale aus dem Oberbegriff des Anspruchs 1 aufweist.

Ein solcher elektrischer Schalter ist aus der DE-OS 35 15 911 bekannt. Bei diesem Schalter ist die Stanzplatine im weitaus größten Bereich ihrer Fläche auf beiden Seiten von Kunststoff umgeben. In diesem Bereich ist die Position der einzelnen Leiterbahnen eindeutig festgelegt. In einem anderen Bereich der Grundplatte, in dem die Leiterbahnen als Festkontakte für bewegliche Kontakte dienen sollen, sind die Leiterbahnen an der einen flachen Seite frei von Kunststoff. In diesem Bereich bilden die eine Flachseite der Leiterbahnen und das angrenzende Material der Grundplatte eine ebene Fläche. Darunter ist eine Fläche zu verstehen, über die bewegliche Schiebekontakte bewegt werden können, ohne daß sie dabei verkippt werden müßten. In diesem Sinne ist auch eine zylindrische Fläche als eben anzusehen.

Die Notwendigkeit, eine Flachseite der Leiterbahnen in einem bestimmten Bereich der Stanzplatine frei von Kunststoff zu lassen, kann aus bestimmten Gründen auch in solchen Bereichen der Stanzplatine erforderlich sein, in denen die Leiterbahnen nicht als Festkontakte für bewegliche Kontakte dienen.

Im dem Bereich der Grundplatte, in denen eine Flachseite einer oder mehrerer Leiterbahnen frei von Kunststoff ist, besteht die Gefahr, daß sich ein Abschnitt einer Leiterbahn aus seinem Sitz in der Grundplatte löst und nach oben vorsteht. Dadurch kann die Funktionsweise des elektrischen Schalters beträchtlich gestört werden.

Der Erfindung liegt die Aufgabe zugrunde, einen elektrischen Schalter, der die Merkmale aus dem Oberbegriff des Anspruchs 1 aufweist, so weiterzuentwickeln, daß die Leiterbahnen auch in einem Bereich der Grundplatte, in dem sie an einer Flachseite frei von Kunststoff sind, fest im Kunststoff sitzen.

Diese Aufgabe wird erfindungsgemäß dadurch gelöst, daß bei einem elektrischen Schalter mit den Merkmalen aus dem Oberbegriff des Anspruch 1 eine Leiterbahn innerhalb des ebenen Flächenbereichs einen Abschnitt aufweist, der tiefer als die ebene Fläche liegt, der mit einer Schmalseite an dem Kunststoff der Grundplatte angrenzt und mit dem die Leiterbahn in der Grundplatte verankert ist. Dadurch, daß der tieferer Abschnitt mit einer Schmalseite an den Kunststoff der Grundplatte angrenzt, ist es sichergestellt, daß über ihn Kunststoff fließen kann, der diesen Abschnitt und damit die Leiterbahn niederhält. Die Leiterbahn ist somit durch diesen Abschnitt in der Grundplatte verankert und die Gefahr, daß sie sich von der Grundplatte löst, ist weitgehend vermieden.

Vorteilhafte Ausgestaltungen eines erfindungsgemäßen elektrischen Schalters kann man den Unteransprüchen entnehmen.

Grundsätzlich ist es möglich, durch eine Welle in einer Leiterbahn einen tiefer liegenden Abschnitt dieser Leiterbahn zu erzeugen, der von Kunststoff bedeckt sein kann. Im Bereich der Welle müßte das Material der Leiterbahn jedoch gezogen werden oder es müßte der gesamte vor der Welle befindliche Leiterbahnabschnitt verschoben werden. Um dies zu vermeiden, und um eine bessere Verbindung des Überdeckenden Kunststoffes mit dem übrigen Kunststoff der Grundplatte zu haben, wird jedoch eine Ausführung gemäß Anspruch 2 bevorzugt. Danach ist der Abschnitt nur in die Grundplatte hineingeführt, jedoch nicht wieder, wie es bei einer Welle der Leiterbahn der Fall wäre, aus der Grundplatte heraus auf das Ausgangsniveau geführt. Eine sehr einfache Möglichkeit, den tiefer liegenden Abschnitt zu erzeugen, ist es, gemäß Anspruch 3 den Abschnitt von der übrigen Leiterbahn ohne Kröpfung einfach um einen Winkel kleiner oder gleich 90 Grad abzubiegen. Eine Kröpfung würde zwei entgegengesetzte Abbiegungen notwendig machen.

Bei einer Ausführung nach Anspruch 4 ist sicher gestellt, daß eine große senkrecht auf die Flachseite des tieferen Abschnitts wirkende Kraftkomponente vorhanden ist.

In einer sehr einfachen und doch sehr wirksamen Ausführung gemäß Anspruch 5 ist der Abschnitt zwar von der Leiterbahn abgebogen, liegt jedoch selbst in einer Ebene, ist also nicht gekrümmt.

Vorteilhafterweise ragt der Abschnitt nicht über die Grundplatte hinaus. Zwischen dem Abschnitt und der übrigen Leiterbahn wird ein Biegewinkel von etwa 15 Grad bevorzugt.

Sind an der gesamten Stanzplantine mindestens zwei abgebogene Abschnitte vorhanden, so ist es besonders vorteilhaft, wenn gemäß Anspruch 8 entsprechende Biegekanten der beiden Abschnitte auf derselben Linie liegen.

Eine bevorzugte Stelle für einen Verankerungsabschnitte an einer Leiterbahn ist gemäß Anspruch 10 ein Bereich, in dem die Leiterbahn in der ebenen Fläche abgewinkelt ist.

Vor allem bei beengten Platzverhältnissen ist es vorteilhaft, den Verankerungsabschnitt gemäß Anspruch 12 als eine zu einer Seitenkante der Leiterbahn hin offene Einkerbung auszubilden.

Die sich gegenüber dem Stand der Technik stellende Aufgabe wird auch durch einen elektrischen Schalter nach Anspruch 14 gelöst. Danach wird eine Seitenkante einer Leiterbahn wenigstens abschnittsweise abgeschrägt, so daß sich eine Art Schwalbenschwanzverbindung zwischen der Leiterbahn und dem Kunststoff ergibt. Auf diese Weise kann die Leiterbahn leicht und platzsparend auf ihrer gesamten Länge verankert werden.

Mehrere Ausführungsbeispiele eines erfindungsgemäßen Lenkstockschalters für Kraftfahrzeuge sind in den Zeichnungen dargestellt. Anhand der Figuren dieser Zeichnungen soll die Erfindung nun näher erläutert werden.

Es zeigen:

Fig. 1 einen Lenkstockschalter mit aus einer Grundplatte und einem Deckel zusammengesetzten Gehäuse und zwei Schalthebeln,

Fig. 2 in vergrößertem Maßstab einen Schnitt durch die Grundplatte des Schalters entlang der Linie II - II aus Fig. 1,

Fig. 3 einen Schnitt entlang der Linie III - III aus Fig. 2,

Fig. 4 in vergrößertem Maßstab einen Schnitt durch einen abgebogenen Verankerungsabschnitt einer Leiterbahn,

Fig. 5 eine Draufsicht auf einen Bereich der Grundplatte einer zweiten Ausführung, bei der eine Leiterbahn eine Einprägung aufweist,

Fig. 6 einen Schnitt entlang der Linie VI-VI aus Figur 5,

Fig. 7 einen Schnitt entlang der Linie VII-VII aus Fig. 5 und

Fig. 8 ein drittes Ausführungsbeispiel mit einer schwalbenschanzartigen Verankerung einer Leiterbahn im Kunststoff.

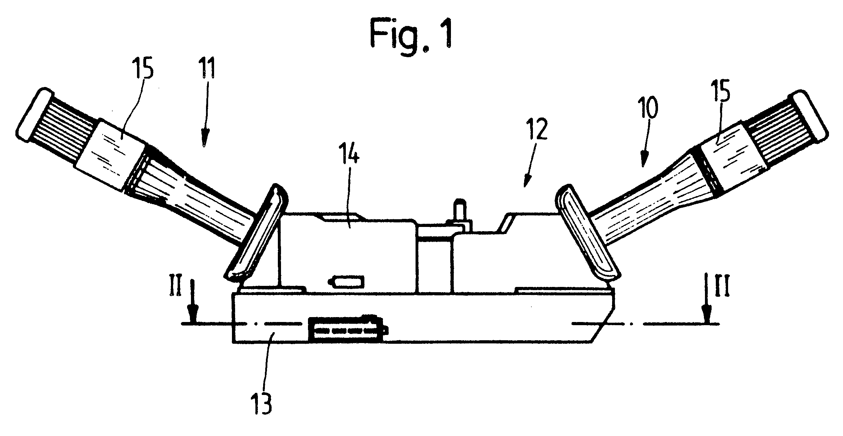

Der in Fig. 1 dargestellte elektrische Schalter ist als Lenkstockschalter für ein Kraftfahrzeug konstruiert und dient dazu, um mit dem einen Schalthebel 10 Wisch- und Waschanlagen für die Front- und Heckscheibe eines Kraftfahrzeuges steuern und mit dem anderen Schalthebel 11 das Stand- und Fahrtlicht sowie die Blinklichter der Fahrtrichtungsanzeige betätigen zu können. Das Gehäuse 12 des Schalters setzt sich im wesentlichen aus einer Grundplatte 13 und einem Deckel 14 zusammen. Im Gehäuse 12 sind die Schalthebel 10 und 11 so gelagert, daß sie um eine Senkrecht auf der Grundplatte 13 stehende Achse horizontal und um eine durch diese gehende und senkrecht darauf stehende Achse vertikal verschwenkt werden können. Außerdem können die Griffe 15 der Schalthebel zusammen mit einer sich im Innern jedes Schalthebels vom Griff bis in das Schaltergehäuse 12 erstreckenden Schaltstange um die Längsachse des jeweiligen Schalthebels gedreht werden.

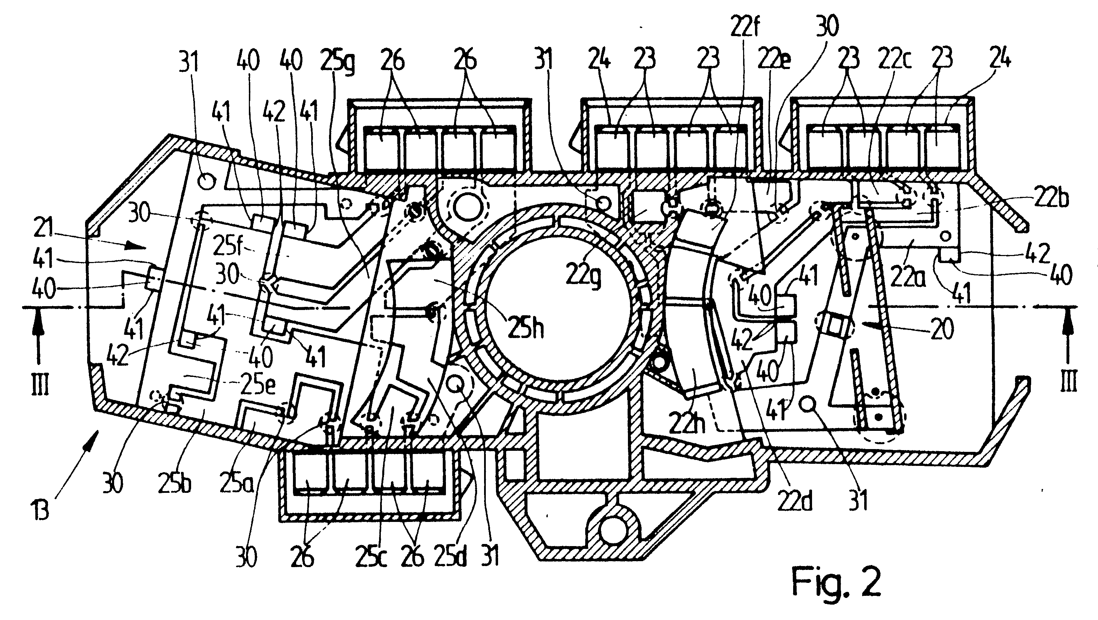

Die Grundplatte 13 des Schalters ist aus Kunststoff im Spritzgießverfahren hergestellt. Während des Spritzvorgangs werden in die Grundplatte 13 zwei Stanzplatinen 20 und 21 aus Kupferblech eingebettet, deren Form näher aus Fig. 2 ersichtlich ist. Die Stanzplatine 20 setzt sich aus insgesamt acht jeweils anders gestalteten Leiterbahnen 22a - 22h zusammen, die in zueinander parallelen, als Flachstecker 23 ausgebildeten Endabschnitten auslaufen, die in zwei Gruppen zu je vier Flachsteckern zusammengefaßt sind und deren freie Stirnflächen 24 auf einer Linie liegen. Auch die Stanzplatine 21 besitzt acht Leiterbahnen, die mit den Bezugszahlen 25a - 25h versehen sind, die ebenfalls in zueinander parallelen, als Flachstecker 26 ausgebildeten Endabschnitten auslaufen, die zu zwei Gruppen zu je vier Flachsteckern zusammengefaßt sind. Im Unterschied zur Stanzplatine 20 zeigen nun jedoch die Flachstecker 26 der einen Gruppe in die eine und die Flachstecker der anderen Gruppe in die entgegengesetzte Richtung.

Damit die einzelnen Leiterbahnen 22a - 22h bzw. 25a - 25h zunächst noch als einstückige Stanzplatine gehandhabt werden können, sind sie durch schmale Brücken 30 nocht miteinander verbunden, die sich jeweils zwischen zwei oder drei Leiterbahnen erstecken. In der Zeichnung sind der Einfachheit halber nicht alle Brücken mit der Bezugszahl versehen. Zum Einbetten der Stanzplatinen 20 und 21 in die Grundplatte 13 werden die Stanzplatinen so, wie sie aus Figur 2 ersichtlich sind, also mit noch über die Brücken 30 verbundenen Leiterbahnen, in das Spritzgießwerkzeug eingelegt. Um sie darin halten zu können, ist aus den Leiterbahnen 22a und 22h sowie 25a und 25h jeweils ein kreisrundes Loch 31 ausgestanzt, in das das Werkzeug mit einem Stift eingreift. Erst nach der Herstellung der Grundplatte werden die Brücken 30 abgestanzt und dadurch die einzelnen Leiterbahnen elektrisch voneinander getrennt.

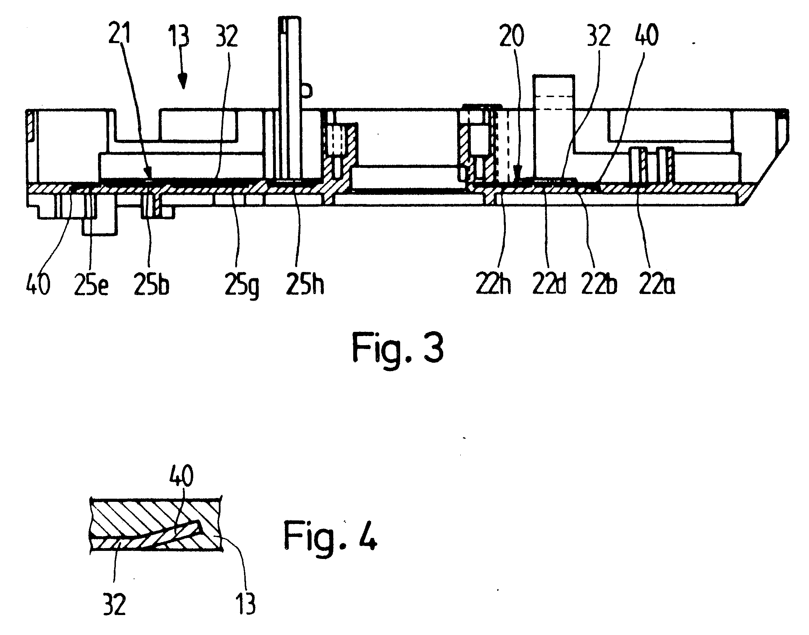

Die Leiterbahnen 22 und 25 dienen in bestimmten Abschnitten als Festkontakte des elektrischen Schalters, auf denen Schiebekontakte entlangbewegt werden können. Sie sind deshalb, wie die Figuren 2 und 3 deutlich zeigen, auf weiten Bereichen ihrer einen Flachseite 32 frei von Kunststoff. In diesen Bereichen liegen sie, wie aus Fig. 3 ersichtlich ist, mit ihrer Flachseite 32 auf gleichem Niveau wie der sie umgebende Kunststoff. Auch konstruktive Gründe, z. B. Platzbedarf für Schieber, können dazu geführt oder dazu beigetragen haben, eine Flachseite der Leiterbahnen in bestimmten Bereichen frei von Kunststoff zu lassen.

Damit die Leiterbahnen auch in den erwähnten Bereichen sicher im Kunststoff eingebettet sind, sind sie mit Verankerungsabschnitten 40 versehen. Diese Abschnitte, die völlig eben sind, sind um einen Winkel von 15° zur der Flachseite 32 gegenüberliegenden Seite von der Leiterbahnen abgebogen. Da jeder Abschnitt 40 in einer Ebene liegt, weisen alle Normalen seiner Flachseite in die gleiche Richtung und schließen mit einer Normalen auf die Ebene, in der die Leiterbahnen liegen, einen Winkel von 15˚ ein. Wie die Fig. 4 deutlich zeigt, tauchen die Abschnitte 40 vollständig in den Kunststoff der Grundplatte 13 ein. Zwischen ihnen und der Unterseite der Grundplatte 13 besteht noch ein Abstand, sie sind also an der Grundplatte 13 weder sichtbar noch ragen sie aus der Grundplatte 13 heraus.

Wie aus Fig. 2 ersichtlich, besitzen beim dargestellten Ausführungsbeispiel die Leiterbahnen 22a, 22b, 22d, 25e, 25f und 25 g jeweils einen Verankerungsabschnitt 40. Die Leiterbahn 25b hat deren zwei. Alle Verankerungsabschnitte 40 sind Ansätze an der jeweiligen Leiterbahn, die eine oder zwei Seitenkanten 41 aufweisen, die mit der anschließenden Seitenkante der Leiterbahn einen Winkel von 90˚ einschließen. Abgesehen von dem Verankerungsabschnitt 40 der Leiterbahn 25e ist eine zweite, parallel zur Seitenkante 41 verlaufende Seitenkante 42 der anderen Verankerungsabschnitte 40 eine gerade Verlängerung einer Seitenkante der jeweiligen Leiterbahn. Beide Seitenkanten 41 bzw. 41 und 42 eines Verankerungsabschnitts 40 sind durch eine senkrecht zu den Seitenkanten verlaufende Vorderkante miteinander verbunden, so daß jeder Verankerungsabschnitt 40 die Form eines Rechtecks·hat. Die Länge der Kanten beträgt jeweils zwischen 4 und 5 mm.

Die beiden Verankerungsabschnitte 40 an den Leiterbahnen 22b und 22d liegen unmittelbar benachbart zueinander und haben Biegekanten, die auf derselben Linie liegen. Entsprechendes gilt für die Verankerungsabschnitte 40 an den Leiterbahnen 25b und 25f. Diese Ausbildung ermöglicht eine Vereinfachung des Stanz- und Biegewerkzeugs.

Der Verankerungsabschnitt 40 an der Leiterbahn 22a befindet sich an einer Stelle, an der die Leiterbahn in der Ebene abgewinkelt ist. Und zwar liegt der Verankerungsabschnitt 40 an der Außenseite der Abwinkelung. Schließlich sind die Verankerungsabschnitte an den Leiterbahnen 22b, 22d, 25b, 25f und 25g an den gegenüber den Flachsteckern entgegengesetzten Enden der Leiterbahnen vorgesehen, da dort die Gefahr, daß sich die Leiterbahn aus dem Kunststoff der Grundplatte 13 löst, besonders groß ist.

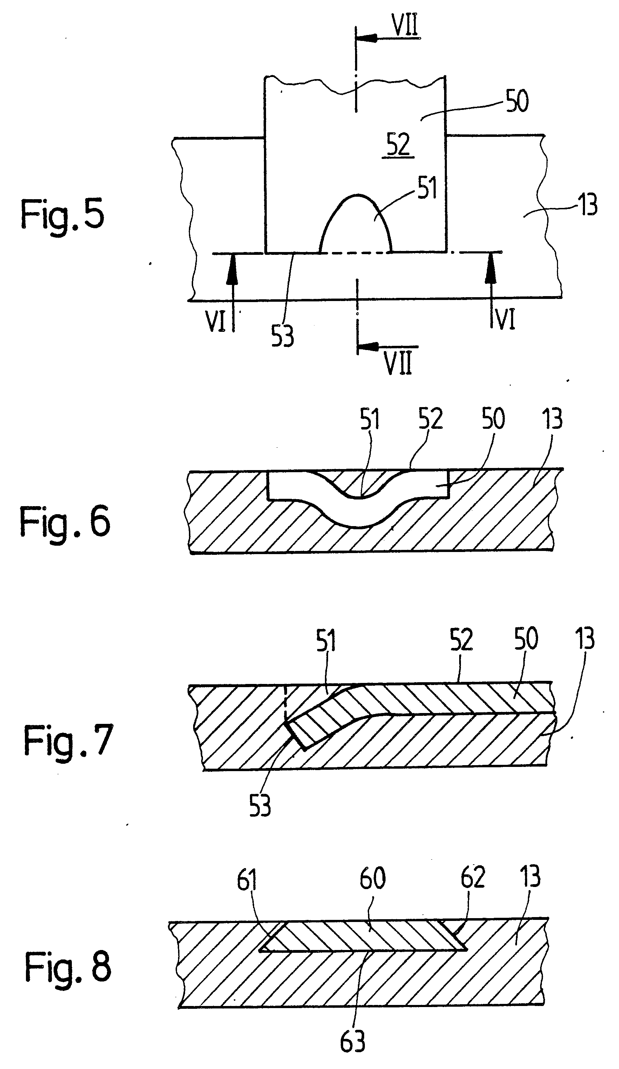

Bei der Ausführung nach den Figuren 5 bis 7 besitzt eine Leiterbahn 50 eine Einkerbung in Form einer Mulde 51, die vom Niveau der Flachseite 52 · schräg zu einer Seitenkante 53 der Leiterbahn 50 abfällt. Beim Spritzgießen der Grundplatte 13 kann Kunststoffmaterial in die Mulde 51 hineinfließen, so daß die Leiterbahn 50 im Kunststoff verankert ist.

Fig. 8 zeigt eine Ausführung, bei der eine Leiterbahn 60 durch eine Schwalbenschwanzverbindung im Kunststoffmaterial der Grundplatte 13 verankert ist. Dazu weist die Leiterbahn 60 zwei Seitenkanten 61 und 62 auf, die mit der Unterseite 63 der Leiterbahn einen Winkel kleiner 90˚ einschließen. Eine gewisse Verankerung der Leiterbahn 60 würde man auch schon dadurch erhalten, daß nur eine Seitenkante 61 und 62 abgeschrängt ist. Freilich sind Abschrägungen an zwei gegenüberliegenden Seitenkanten besonders vorteilhaft.

Die Abschrägung einer Seitenkante wird vorteilhafterweise während des Stanzvorgangs angeprägt.

## Ansprüche

1. Elektrischer Schalter, insbesondere Lenkstockschalter für Kraftfahrzeuge, mit einer Grundplatte (13) aus Kunststoff und mit mehreren metallischen Leiterbahnen (22a - 22h, 25a - 25h, 50), die aus einer Blechplatine ausgestanzt und in die Grundplatte (13) eingegossen sind, wobei innerhalb eines Bereichs der Grundplatte (13) die eine Flachseite (32, 52) einer oder mehrerer Leiterbahnen (22a - 22h, 25a - 25h, 50) und das angrenzende Material der Grundplatte (13) eine ebene Fläche bilden, dadurch gekennzeichnet, daß eine Leiterbahn (22a, 22b, 22d, 25b, 25e, 25f, 25g, 50) innerhalb des ebenen Flächenbereichs einen Abschnitt (40, 51) aufweist, der tiefer als die ebene Fläche liegt, der mit einer Schmalseite (41, 42, 53) an den Kunststoff der Grundplatte (13) angrenzt und mit dem die Leiterbahn (22a, 22b, 22d, 25b, 25e, 25f, 25g ,50) in der Grundplatte (13) verankert ist.

2. Elektrischer Schalter nach Anspruch 1, dadurch gekennzeichnet, daß der Abschnitt (40, 51) nur in die Grundplatte (13) hineingeführt, jedoch nicht wieder aus ihr heraus auf das Ausgangsniveau geführt ist.

3. Elektrischer Schalter nach Anspruch 1 oder 2, dadurch gekennzeichnet, daß der Abschnitt (40) von der übrigen Leiterbahn (22a, 22b, 22d, 25b, 25e, 25f, 25g) einfach um einen Winkel kleiner oder gleich 90 Grad abgebogen ist.

4. Elektrischer Schalter nach einem der Ansprüche 1 bis 3, dadurch gekennzeichnet, daß im jedem Punkt einer Flachseite des Abschnitts (40, 51) eine Normale auf die Flachseite mit der Normalen auf die ebene Fläche einen Winkel einschließt, der wesentlich kleiner als 90 Grad, vorzugsweise kleiner als 45 Grad ist.

5. Elektrischer Schalter nach einem der Ansprüche 2 bis 4, dadurch gekennzeichnet, daß der Abschnitt (40) in einer Ebene liegt.

6. Elektrischer Schalter nach einem der Ansprüche 1 bis 5, dadurch gekennzeichnet, daß der Abschnitt (40, 51) ganz innerhalb der Grundplatte (13) liegt, vorzugsweise zwischen dem Abschnitt (40, 51) und der Unterseite der Grundplatte (13) ein Abstand besteht.

7. Elektrischer Schalter nach Anspruch 5 oder 6, dadurch gekennzeichnet, daß der Biegewinkel zwischen dem Abschnitt (40) und der übrigen Leiterbahn (22a, 22b, 22d, 25b, 25e, 25f, 25g) etwa 15 Grad beträgt.

8. Elektrischer Schalter nach einem der vorhergehenden Ansprüche, dadurch gekennzeichnet, daß mindestens zwei abgebogene Abschnitte (40) vorhanden sind, die sich an einer oder zwei verschiedenen Leiterbahnen (22b, 22d; 25b, 25f) befinden, und daß entsprechende Biegekanten der beiden Abschnitte (40) auf derselben Linie liegen.

9. Elektrischer Schalter nach einem der vorhergehenden Ansprüche, dadurch gekennzeichnet, daß die Leiterbahn (22a) in der ebenen Fläche abgewinkelt ist und daß sich ein Verankerungsabschnitt (40) im Bereich der Abwinkelung an deren Außenseite befindet.

10. Elektrischer Schalter nach einem der vorhergehenden Ansprüche, dadurch gekennzeichnet, daß die Breite der Verankerungsabschnitts (40) senkrecht zur Biegekante 4 bis 5 mm beträgt.

11. Elektrischer Schalter nach einem der vorhergehenden Ansprüche, dadurch gekennzeichnet, daß die Breite des Verankerungsabschnitts (40) längs der Biegekante 4 bis 5 mm beträgt.

12. Elektrischer Schalter nach einem der vorhergehenden Ansprüche, dadurch gekennzeichnet, daß der Verankerungsabschnitt eine zu einer Seitenkante (53) einer Leiterbahn (50) hin offene Einkerbung (51) ist.

13. Elektrischer Schalter nach Anspruch 12, dadurch gekennzeichnet, daß die Einkerbung eine vom Niveau der Flachseite (52) einer Leiterbahn (50) aus zur Seitenkante (53) hin schräg abfallende Mulde (51) ist.

14. Elektrischer Schalter, insbesondere Lenkstockschalter für Kraftfahrzeuge, mit einer Grundplatte (13) aus Kunststoff und mit wenigstens einer metallischen Leiterbahn (60), die aus einer Blechplatine ausgestanzt und in die Grundplatte (13) eingegossen ist, wobei innerhalb eines Bereichs der Grundplatte (13) die eine Flachseite (52) einer oder mehrerer Leiterbahnen (60) und das angrenzende Material der Grundplatte (13) eine ebene Fläche bilden, dadurch gekennzeichnet, daß eine Leiterbahn (60) innerhalb des ebenen Flächenbereichs eine Seitenkante (61, 62) aufweist, die wenigstens abschnittsweise mit der ebenen Fläche einen Winkel kleiner als 90° einschließt, so daß sich eine schwalbenschwanzartige Verankerung der Leiterbahn (60) im Kunststoff ergibt.

15. Elektrischer Schalter nach Anspruch 14, dadurch gekennzeichnet, daß die Schräge der Seitenkante (61, 62) während des Stanzvorgangs ausgeprägt wird.

# Fig. 1

EP 0 297 388 A1

Fig. 2

EP 0 297 388 A1

21  13  32          20    32  40

40  25e  25b    25g  25h        22h  22d  22b  22a

## Fig. 3

40

## Fig. 4

32          13

**Fig.5**

**Fig.6**

**Fig.7**

**Fig.8**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 219 579 (KABUSHIKI)<br>* Seite 1, Zeile 1 - Seite 6, Zeile 9;<br>Seite 7, Zeile 6 - Seite 10, Zeile 2 * | 1-13 | H 01 H 1/40<br>H 01 H 11/00 |
| Y | --- | 14,15 | |
| Y | BE-A- 722 819 (SCHOELLER)<br>* Seite 2, letzter Absatz - Seite 3,<br>Zeile 5; Seite 3, Zeilen 9-11; Seite 3,<br>Zeilen 25-27; Seite 4, Zeilen 10-14 * | 14,15 | |
| A | --- | 1 | |
| A | FR-A-2 021 098 (PHILIPS)<br>* Seite 2, Zeile 3 - Seite 3, Zeile 11<br>* | 1-5,7-11 | |
| A | --- <br>DE-C- 847 317 (AGFA)<br>* Seite 2, Zeilen 43-66,97-104 *<br>--- | 1-11 | |
| A | US-A-3 219 785 (ALLISON)<br>* Spalte 3, Zeile 41 - Spalte 4, Zeile<br>41; Spalte 5, Zeilen 46-69 *<br>--- | 1,12-15 | |
| A | US-A-3 862 389 (LOWE)<br>* Spalte 1, Zeilen 40-47 *<br>--- | 1,14,15 | RECHERCHIERTE SACHGEBIETE (Int. Cl.4)<br><br>H 01 H 11/00 |
| D,A | EP-A-0 200 175 (SWF)<br>----- | | |

Der vorliegende Recherchenbericht wurde für alle Patentansprüche erstellt

| Recherchenort | Abschlußdatum der Recherche | Prüfer |
|---|---|---|
| DEN HAAG | 23-09-1988 | DESMET W.H.G. |